# EUROPÄISCHE PATENTSCHRIFT

(11) **EP 3 372 057 B1**
(45) Veröffentlichungstag und Bekanntmachung des Hinweises auf die Patenterteilung: **18.09.2019**
(21) Anmeldenummer: 16787370.2
(22) Anmeldetag: 19.10.2016
(51) Int. Cl.: H05K 1/02

(54) **VERFAHREN ZUR REDUZIERUNG VON LEITERBAHNABSTÄNDEN BEI ELEKTRONISCHEN LEITERPLATTEN UND ELEKTRONISCHE LEITERPLATTE MIT REDUZIERTEN ABSTÄNDEN ZWISCHEN LEITERBAHNEN**
METHOD FOR REDUCING CONDUCTOR TRACK SPACING IN ELECTRONIC CIRCUIT BOARDS AND ELECTRONIC CIRCUIT BOARD WITH REDUCED SPACING BETWEEN CONDUCTOR TRACKS
PROCÉDÉ DE RÉDUCTION DE DISTANCES ENTRE PISTES CONDUCTRICES DANS DES CARTES DE CIRCUITS IMPRIMÉS ÉLECTRONIQUES ET CARTE DE CIRCUITS IMPRIMÉS ÉLECTRONIQUE AYANT DES DISTANCES RÉDUITES ENTRE LES PISTES CONDUCTRICES

(30) Priorität: 05.11.2015 DE 102015221688
(43) Veröffentlichungstag der Anmeldung: 12.09.2018
(73) Patentinhaber: OSRAM GmbH, 80807 München (DE)
(72) Erfinder: HUMMEL, Peter, 81927 München (DE); MANNHARDT, Stefan, 82541 Münsing (DE)
(86) Internationale Anmeldenummer: PCT/EP2016/075049
(87) Internationale Veröffentlichungsnummer: WO 2017/076641

(56) Entgegenhaltungen:
- EP-A2- 1 289 341
- DE-A1-102005 046 282
- US-A1- 2002 158 590
- US-A1- 2010 039 838
- US-A1- 2012 127 684

## Beschreibung

### Technisches Gebiet

Die Erfindung betrifft ein Verfahren zur Reduzierung von Leiterbahnabständen auf einer Leiterplatte und eine entsprechende Leiterplatte mit reduzierten Leiterbahnabständen.

### Hintergrund

Die Erfindung geht aus von einem Verfahren zur Reduzierung von Leiterbahnabständen einer Leiterplatte und von einer Leiterplatte mit einer Schaltungsanordnung mit reduzierten Leiterbahnabständen nach der Gattung der Ansprüche 1 und 7.

Schaltnetzteile lassen sich grundsätzlich in zwei Gruppen unterteilen, galvanisch isolierte und nicht isolierte Schaltnetzteile. Isolierte Schaltnetzteile weisen einen Eingangsteil und einen davon elektrisch isolierten Ausgangsteil auf. Der Eingangsteil ist Netzspannungsführend, und so ausgestaltet, dass er von einem Benutzer nicht berührt werden kann.

Der Ausgang ist aus Handlings- und Kostengründen meist isoliert von der Netzspannung ausgeführt. Die isolierte Ausgangsspannung kann im SELV - Bereich liegen (bis 120V) aber auch höhere Spannungen aufweisen.

Die isolierte Ausgangsspannung ermöglicht einen deutlich reduzierten Isolieraufwand bei LED Modulen, welches aus thermischen Gründen sehr vorteilhaft ist und kompakte Designs ermöglicht.

Speziell bei Schaltnetzteilen, die für LED-Beleuchtung vorgesehen sind, sind isolierte SELV-konforme Schaltnetzteile sehr verbreitet, da die LEDs bei höheren Leistungen eine ausreichende Kühlung benötigen und mitunter auf größere, von außen berührbare metallisch leitende Kühlkörper montiert sind. Um die einschlägigen Sicherheitsnormen wie die IEC 61347-1 einhalten zu können, sind zwischen dem nicht berührbaren Eingangsteil und dem (berührbaren) Ausgangsteil Sicherheitsabstände vorgesehen, die in Form einer Kriechstrecke eingehalten werden müssen.

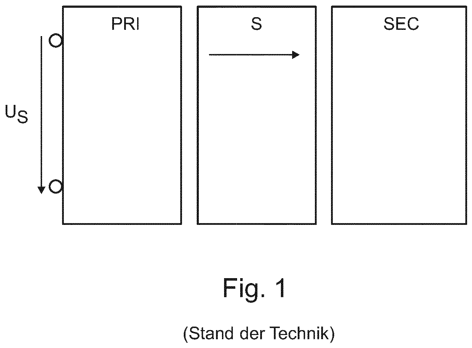

Fig.1 zeigt eine schematische Darstellung einer dem Sicherheitsstandard gemäß IEC 61347-1 konformen Ausführung eines isolierten Schaltnetzteils nach dem Stand der Technik. Der Eingangsteil PRI, der von der Netzspannung Us gespeist wird, ist durch einen Sicherheitsabstand S vom Ausgangsteil SEC getrennt. Die gemäß IEC 61347-1 einzuhaltenden Kriechstrecken sind abhängig von der maximal auftretenden Spannung zwischen den entsprechenden Bauteilen definiert.

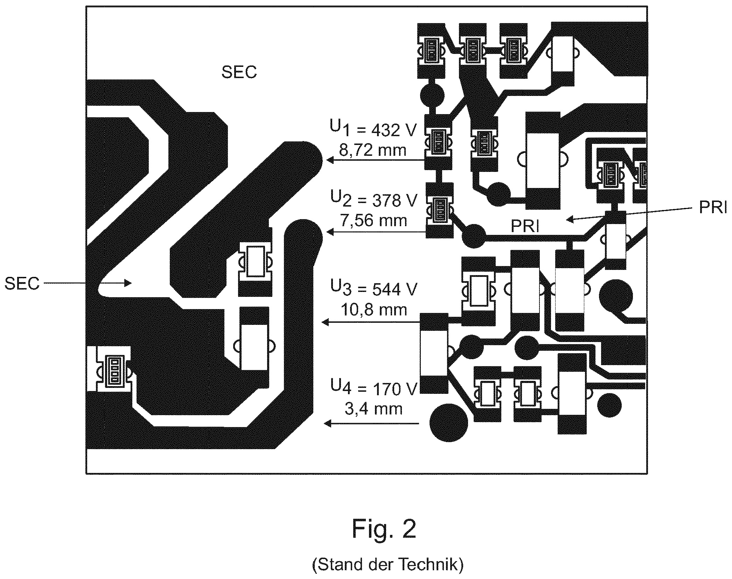

Fig. 2 zeigt beispielhaft einen Ausschnitt eines Leiterplattenlayouts einer dem Sicherheitsstandard gemäß IEC 61347-1 konformen Ausführung nach dem Stand der Technik. Der rechte Teil des Layouts umfasst den Eingangsteil PRI, der netzspannungsführende leitfähige Teile (Bauteile, Leiterbahnen,..) aufweist, und mechanisch so ausgestaltet ist, dass spannungsführende Teile von außen nicht berührt werden können. Dies kann durch entsprechende Gestaltung des Gehäuses und der Anschlussklemmen des Schaltnetzteils erreicht werden. Auf der linken Seite des Layouts ist der Ausgangsteil SEC angeordnet. Der Ausgangsteil ist berührbar ausgestaltet, da an seinem Ausgang eine Schutzkleinspannung anliegt, und die vom Schaltnetzteil zu betreibenden LED-Module z.B. berührbar sein können.

Zwischen dem Eingangsteil PRI und dem Ausgangsteil SEC ist eine Kriechstrecke gemäß IEC 61347-1 vorgesehen. Diese Norm schreibt bestimmte Kriechstrecken anhand der Spannungen zwischen zwei Bauteilen zwischen Eingangs- und Ausgangsteil vor.

In Fig. 2 sind beispielhaft verschiedene notwendige Kriechstreckenabstände anhand der zwischen den entsprechenden leitfähigen Teilen anliegenden Spannung dargestellt.

Die maximal auftretende erste Spannung U₁ zwischen den entsprechenden Bauteilen beträgt z.B. 432V. Hierfür ist gemäß IEC 61347-1 eine Mindestkriechstrecke von 8,64 mm zwischen den entsprechenden Bauteilen vorgesehen. Die maximal auftretende zweite Spannung U₂ zwischen den entsprechenden Bauteilen beträgt z.B. 378V. Hierfür ist gemäß IEC 61347-1 eine Mindestkriechstrecke von 7,56mm zwischen den entsprechenden Bauteilen vorgesehen.

Die maximal auftretende dritte Spannung U₃ zwischen den entsprechenden Bauteilen beträgt z.B. 544V. Hierfür ist gemäß IEC 61347-1 eine Mindestkriechstrecke von 10,8mm zwischen den entsprechenden Bauteilen vorgesehen.

Die maximal auftretende vierte Spannung U₄ zwischen den entsprechenden Bauteilen beträgt z.B. 170V. Hierfür ist gemäß IEC 61347-1 eine Mindestkriechstrecke von 3,4mm zwischen den entsprechenden Bauteilen vorgesehen. Speziell bei Sperrwandlern können funktionsbedingt hohe Spannungen bei einigen Bauteilen auftreten, was in der Praxis wie bei der dritten Spannung U₃ zu großen notwendigen Kriechstrecken führen kann. Dies vergrößert das notwendige Bauvolumen des Schaltnetzteils und ist daher unerwünscht. Gerade bei Schaltnetzteilen in der Beleuchtungstechnik ist es bei komplexeren Designs üblich, sogenannte Add-on Boards zu verwenden, die senkrecht auf der Hauptplatine angebracht werden, um Länge auf der Hauptplatine einzusparen. Kleinere Kriechstrecken könnten hierbei Platz für Komponenten machen und auf Add-on Boards könnte verzichtet werden.

Bisheriger Stand der Technik ist in den Patentschriften US 2010/039838 A1, DE 10 2005 046282 A1, US 2012/127684 A1, US 2002/158590 A1 und EP 1 289 341 A2 offenbart.

### Aufgabe

Es ist Aufgabe der Erfindung, ein Verfahren und eine Leiterplatte mit einer Schaltungsanordnung anzugeben, welches die notwendigen Sicherheitsabstände bei den Kriechstrecken der Leiterplatte mit der Schaltungsanordnung verringert.

### Darstellung der Erfindung

Die Lösung der Aufgabe erfolgt erfindungsgemäß mit einem Verfahren zur Reduzierung von Leiterbahnabständen einer Leiterplatte, wobei die Leiterplatte einen von einer Versorgungsspannung gespeisten Eingangsteil und einen Ausgangsteil aufweist, gekennzeichnet durch die Schritte Einfügen einer Zwischenleiterbahn welche ein aus dem Eingangsteil abgeleitetes Zwischenpotential aufweist, Einhalten eines funktionalen Isolationsabstandes (der Zwischenleiterbahn zu benachbarten Leiterbahnen des Eingangsteils, Einhalten eines sicherheitsrelevanten Isolationsabstandes der Zwischenleiterbahn zu den benachbarten Leiterbahnen des Ausgangsteils, wobei das Zwischenpotential eine Spannung gegenüber benachbarten Leiterbahnen des Ausgangsteils aufweist, die maximal der Versorgungsspannung des Eingangsteils entspricht.

Durch das erfindungsgemäße Einfügen eines Zwischenpotentials zwischen Eingangsteil und Ausgangsteil können die vorgeschriebenen Kriechstrecken einfacher eingehalten werden, da sie bei geeigneter Wahl des Potentials wesentlich kleiner ausfallen. Die Spannungsabstände des Zwischenpotentials gegenüber dem Eingangsteil unterliegen keinen normativen Sicherheitsvorschriften und können durch geeignete Maßnahmen sehr klein gehalten werden. Insgesamt verbessert sich damit der Platzbedarf auf einer Leiterplatte aufgrund der kleineren Abstände der Leiterbahnen signifikant, trotz dem Einfügen der Zwischenleiterbahn zwischen Eingangsteil und Ausgangsteil.

Prinzipiell kann die Spannung des Zwischenpotentials gegenüber benachbarten Leiterbahnen des Ausgangsteils auch höher sein als die Versorgungsspannung, wenn diese Spannung funktionell sehr nahe am Potential der leitenden Teile im Isolierbereich des Eingangsteils ist.

Es soll betont werden, dass sich die sicherheitsrelevanten Kriechstrecken zwischen dem Zwischenpotential und dem Ausgangsteil an der jeweils höchsten auftretenden Spannung orientieren.

In einer üblichen Ausführungsvariante ist das Eingangsteil nicht berührbar ausgestaltet. Dies ist schon aufgrund der in den meisten Ländern üblichen Netzspannung von 230V oder 120V notwendig.

Bevorzugt weist das Ausgangsteil berührbare Bauteile auf. Dadurch verbessert sich das Handling des Gesamtsystems enorm, da an den Ausgangsteil oftmals LED-Module angeschlossen werden, die als einzelne Platine ohne Gehäuse ausgestaltet sind, und somit spannungsführende Potentiale berührbar sind. Da diese Module üblicherweise mit einer SELV Spannung kleiner 60V betrieben werden stellt dies kein Sicherheitsproblem dar.

Es ist jedoch nicht zwingend notwendig, dass das Ausgangsteil berührbar ist, die Erfindung weist auch bei nicht berührbarem Ausgangsteil erhebliche Vorteile gegenüber dem Stand der Technik auf.

In einer besonders bevorzugten Ausführungsform wird das Zwischenpotential aus dem Potential am negativen Ausgang eines im Eingangsteil befindlichen Brückengleichrichters erzeugt. Diese Maßnahme ist besonders einfach umzusetzen und das Potential am negativen Ausgang eines im Eingangsteil befindlichen Brückengleichrichters ist für das erfindungsgemäße Verfahren besonders geeignet.

In einer anderen Ausführungsform weist das Zwischenpotential ein Potential auf, welches einer niedrigeren Spannung als der Spannung zwischen Eingangsteil und Ausgangsteil gegenüber einem Erdpotential oder einem Potential des Nullleiters der Versorgungsspannung entspricht. Sofern das Zwischenpotential also "zwischen" der Spannung am Eingangsteil und der Spannung am Ausgangsteil liegt, kann die erfindungsgemäße Lösung vorteilhaft umgesetzt werden.

In einer vorteilhaften Ausführungsform sind zwischen der Zwischenleiterbahn und benachbarten Leiterbahnen des Eingangsteils oder benachbarten Leiterbahnen des Ausgangsteils Aussparungen in der Leiterplatte zur Erhöhung des Isolationsabstandes vorgesehen. Diese Aussparungen können den Isolationsabstand verringern, da sie die notwendigen Kriechstrecken zwischen den Leiterbahnen bei gleichem Abstand der Leiterbahnen signifikant erhöhen. Der Abstand zwischen den Leiterbahnen kann somit vorteilhaft verringert werden, so dass mehr Platz auf der Leiterplatte verfügbar wird.

Die Lösung der Aufgabe erfolgt weiterhin erfindungsgemäß mit einer Leiterplatte mit einer Schaltungsanordnung, aufweisend einen Eingangsteil welcher von einer Versorgungsspannung gespeist wird, und einen Ausgangsteil, wobei die Leiterplatte zwischen dem Eingangsteil und dem Ausgangsteil eine Zwischenleiterbahn aufweist, welche ein aus dem Eingangsteil abgeleitetes Zwischenpotential aufweist, wobei die Zwischenleiterbahn zu den benachbarten Leiterbahnen des Eingangsteils einen funktionalen Isolationsabstand einhält, wobei die Zwischenleiterbahn zu den benachbarten Leiterbahnen des Ausgangsteils einen sicherheitsrelevanten Isolationsabstand einhält, und wobei das Zwischenpotential eine Spannung gegenüber benachbarten Leiterbahnen des Ausgangsteils aufweist, die maximal der Versorgungsspannung des Eingangsteils entspricht oder das Zwischenpotential ein Potential mit einer dem Wert nach kleineren Spannung als der Spannung zwischen Eingangsteil und Ausgangsteil (U₁, U₂, U₃, U₄) gegenüber einem Erdpotential oder einem Potential des Nullleiters der Versorgungsspannung aufweist. Eine solche Platine hat den Vorteil, dass sie weniger Fläche zwischen dem Eingangsteil und dem Ausgangsteil benötigt, um die vorgeschriebenen Sicherheitsnormen einzuhalten als die im Stand der Technik bekannten Platinen.

In einer üblichen Ausführungsvariante ist das Eingangsteil der Leiterplatte nicht berührbar ausgestaltet. Dies ist schon aufgrund der in den meisten Ländern üblichen Netzspannung von 230V oder 120V notwendig.

In einer Ausführungsform weist das Ausgangsteil der Leiterplatte berührbare Bauteile auf. Dadurch verbessert sich das Handling des Gesamtsystems enorm, da an den Ausgangsteil oftmals LED-Module angeschlossen werden, die als einzelne Platine ohne Gehäuse ausgestaltet sind, und somit spannungsführende Potentiale berührbar sind. Da diese Module üblicherweise mit einer SELV Spannung von maximal 60V betrieben werden stellt dies kein Sicherheitsproblem dar.

Es ist jedoch nicht zwingend notwendig, dass das Ausgangsteil berührbar ist, die Erfindung weist auch bei nicht berührbarem Ausgangsteil erhebliche Vorteile gegenüber dem Stand der Technik auf.

In einer besonders bevorzugten Ausführungsform wird das Zwischenpotential der Leiterplatte aus dem Potential am negativen Ausgang eines im Eingangsteil befindlichen Brückengleichrichters erzeugt. Diese Maßnahme ist besonders einfach umzusetzen und das Potential am negativen Ausgang eines im Eingangsteil befindlichen Brückengleichrichters ist für das erfindungsgemäße Verfahren besonders geeignet.

In einer vorteilhaften Ausführungsform sind zwischen der Zwischenleiterbahn und benachbarten Leiterbahnen des Eingangsteils der Leiterplatte oder benachbarten Leiterbahnen des Ausgansteils der Leiterplatte Aussparungen in der Leiterplatte zur Erhöhung des Isolationsabstandes vorgesehen. Diese Aussparungen können den Isolationsabstand verringern, da sie die notwendigen Kriechstrecken zwischen den Leiterbahnen bei gleichem Abstand der Leiterbahnen signifikant erhöhen. Der Abstand zwischen den Leiterbahnen kann somit vorteilhaft verringert werden, so dass insgesamt mehr Platz auf der Leiterplatte verfügbar wird.

In einer weiteren Ausführungsform weist das Zwischenpotential der Leiterplatte ein Potential auf, welches einer niedrigeren Spannung als der Spannung zwischen Eingangsteil und Ausgangsteil gegenüber einem Erdpotential oder einem Potential des Nullleiters der Versorgungsspannung entspricht. Sofern diese Voraussetzung gegeben ist kann die erfindungsgemäße Lösung vorteilhaft umgesetzt werden.

Weitere vorteilhafte Weiterbildungen und Ausgestaltungen des erfindungsgemäßen Verfahrens und der erfindungsgemäßen Leiterplatte ergeben sich aus weiteren abhängigen Ansprüchen und aus der folgenden Beschreibung.

Im Folgenden werden zwei ähnliche Begriffe verwendet, deren Bedeutung im folgenden Kontext kurz erläutert werden soll.

Die Kriechstrecke bezeichnet die gemäß IEC 61347-1 vorgegebenen Abstände zwischen zwei leitfähigen spannungsführenden Teilen wie zwei Leiterbahnen oder zwischen Leiterbahnen und Bauteilepads oder zwischen zwei Bauteilepads oder zwei Bauteilen wie z.B. einem Trafokern oder Kühlkörper. Da sich hier ein Spannungsdurchschlag üblicherweise nicht durch die Luft ausbildet sondern entlang der Oberfläche der Leiterplatte, ist die entsprechende Kriechstrecke zwischen den entsprechenden leitfähigen Teilen maßgeblich.

Als Spannungsabstand wird hier ganz allgemein der Abstand zwischen zwei leitenden Flächen angesehen, unabhängig vom Medium, in dem sich ein elektrischer Durchschlag ausbilden kann. Der Begriff Spannungsabstand ist im folgenden Kontext also weiter gefasst.

### Kurze Beschreibung der Zeichnungen

Weitere Vorteile, Merkmale und Einzelheiten der Erfindung ergeben sich anhand der nachfolgenden Beschreibung von Ausführungsbeispielen sowie anhand der Zeichnungen, in welchen gleiche oder funktionsgleiche Elemente mit identischen Bezugszeichen versehen sind. Dabei zeigen:
- Fig.1: eine schematische Darstellung einer dem Sicherheitsstandard gemäß IEC 61347-1 konformen Ausführung nach dem Stand der Technik,
- Fig. 2: ein Leiterplattenlayout einer dem Sicherheitsstandard gemäß IEC 61347-1 konformen Ausführung nach dem Stand der Technik
- Fig. 3: eine schematische Darstellung einer gegenüber dem Stand der Technik verbesserten, dem Sicherheitsstandard gemäß IEC 61347-1 konformen Ausführungsform,
- Fig. 4: ein Leiterplattenlayout einer gegenüber dem Stand der Technik verbesserten, dem Sicherheitsstandard gemäß IEC 61347-1 konformen Ausführungsform

### Bevorzugte Ausführung der Erfindung

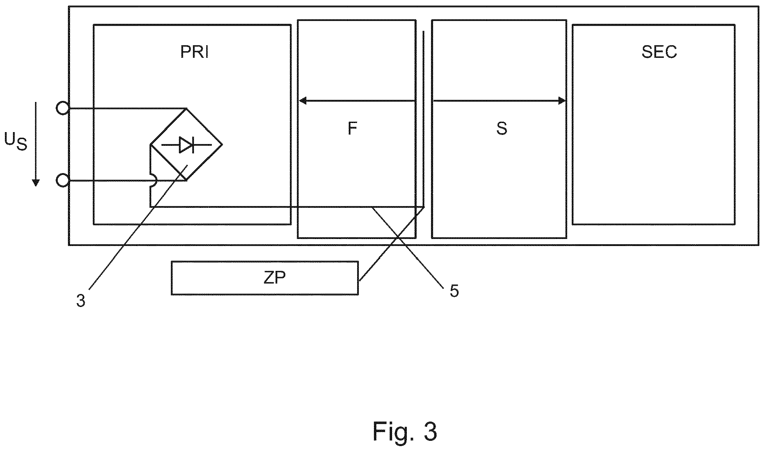

Fig. 3 zeigt eine schematische Darstellung einer verbesserten, dem Sicherheitsstandard gemäß IEC 61347-1 konformen Ausführungsform der Leiterplatte mit einer darauf angeordneten Schaltungsanordnung. Die Schaltungsanordnung weist einen Eingangsteil PRI und einen Ausgangsteil SEC auf, die gemäß obiger Norm durch bestimmte Kriechstrecken auf der Leiterplatte getrennt sein müssen. Für die Trennung ist eine sicherheitsrelevante Kriechstrecke S gefordert, die zwischen dem Eingangsteil und dem Ausgangsteil eingehalten werden muss. Um die in der Praxis aufgrund der hohen Spannung sehr großen Kriechstrecken zwischen bestimmten Bauteilen zu reduzieren, wird eine Leiterbahn 5 zwischen dem Eingangsteil PRI und dem Ausgangsteil SEC eingeführt. Diese Leiterbahn 5 weist als Potential ein Zwischenpotential ZP auf, welches aus dem Eingangsteil PRI abgeleitet ist. Das Zwischenpotential ZP ist in dieser Ausführungsform der negative Ausgang des Brückengleichrichters 3 im Eingangsteil. Das Potential weist gegenüber allen spannungsführenden Bauteilen des Ausgangsteils eine Differenzspannung auf, die nicht höher ist als die Speisespannung Us des Gerätes. Durch diese Maßnahme ist die sicherheitsrelevante Kriechstrecke auf die Speisespannung des Gerätes begrenzt und nicht sonderlich groß. Zu den Bauteilen des Eingangsteils muss keine sicherheitsrelevante Kriechstrecke eingehalten werden, es ist ein funktionaler Abstand ausreichend. Bei höheren Spannungen zwischen einzelnen Bauteilen und dem Zwischenpotential ZP können Aussparungen beziehungsweise Durchbrüche in der Leiterplatte vorgesehen sein, die die Kriechstrecke erhöhen.

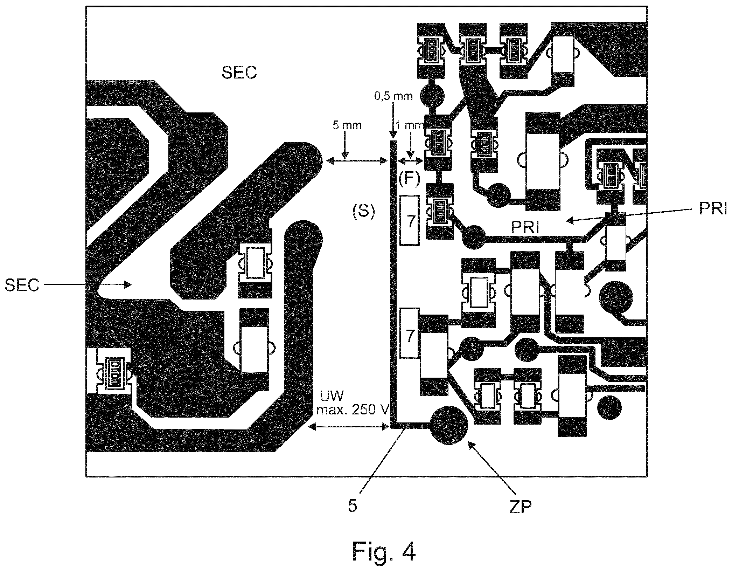

Fig. 4 zeigt einen Ausschnitt eines Leiterplattenlayouts einer dem Sicherheitsstandard gemäß IEC 61347-1 konformen Ausführungsform, in dem obige Ausführungen umgesetzt sind. Die Leiterbahn 5 zwischen dem Eingangsteil PRI und dem Ausgangsteil SEC schirmt die Bauteile des Eingangsteils PRI vom Ausgangsteil SEC ab und reduziert so die Kriechstrecke insgesamt um über 4mm. Da maximal 250V zwischen der Leiterbahn 5 und dem Ausgangsteil SEC anliegen, sind hier lediglich 5mm Kriechstrecke vorgeschrieben. Der funktionale Spannungsabstand zum Eingangsteil PRI kann durch die Durchbrüche 7 weiter optimiert werden, da er die dort notwendige funktionale Kriechstrecke erhöht und so den realen Abstand von der Leiterbahn 5 zum entsprechenden Bauteil verringert. Damit ist zwischen der Leiterbahn 5 und den Bauteilen nur noch ein Abstand von 1 mm notwendig. Der reale Abstand zwischen Eingangsteil und Ausgangsteil schrumpft damit auf 6,5mm gegenüber 10,8mm in der Ausführung gemäß Fig. 2, die dem Stand der Technik entspricht.

### Bezugszeichenliste

- 3: Brückengleichrichter
- 5: Zwischenleiterbahn
- 7: Aussparungen
- PRI: Eingangsteil
- SEC: Ausgangsteil
- ZP: Zwischenpotential
- F: funktionaler Isolationsabstand
- S: sicherheitsrelevanter Isolationsabstand
- U_{S}: Versorgungsspannung
- ZP: Zwischenpotential

## Patentansprüche

1. Verfahren zur Reduzierung von Leiterbahnabständen einer Leiterplatte, wobei die Leiterplatte einen von einer Versorgungsspannung (U_{S}) gespeisten Eingangsteil (PRI) und einen Ausgangsteil (SEC) aufweist, **gekennzeichnet durch** folgende Schritte:
- Einfügen einer Zwischenleiterbahn welche ein aus dem Eingangsteil (PRI) abgeleitetes Zwischenpotential (ZP) aufweist,
- Einhalten eines funktionalen Isolationsabstandes (F) der Zwischenleiterbahn (5) zu benachbarten Leiterbahnen des Eingangsteils (PRI),
- Einhalten eines sicherheitsrelevanten Isolationsabstandes (S) der Zwischenleiterbahn zu den benachbarten Leiterbahnen des Ausgangsteils (SEC),
wobei das Zwischenpotential eine Spannung gegenüber benachbarten Leiterbahnen des Ausgangsteils (SEC) aufweist, die maximal der Versorgungsspannung (U_{S}) des Eingangsteils entspricht.

2. Verfahren gemäß Anspruch 1, **dadurch gekennzeichnet, dass** das Eingangsteil (PRI) nicht berührbar ist.

3. Verfahren gemäß Anspruch 1 oder 2, **dadurch gekennzeichnet, dass** das Ausgangsteil (SEC) berührbare Bauteile aufweist.

4. Verfahren gemäß einem der Ansprüche 1 bis 3, **dadurch gekennzeichnet, dass** das Zwischenpotential (ZP) aus dem Potential am negativen Ausgang eines im Eingangsteil befindlichen Brückengleichrichters (3) erzeugt wird.

5. Verfahren gemäß einem der Ansprüche 1 bis 3, **dadurch gekennzeichnet, dass** das Zwischenpotential (ZP) ein Potential aufweist, welches einer niedrigeren Spannung als der Spannung zwischen Eingangsteil und Ausgangsteil (U₁, U₂, U₃, U₄) gegenüber einem Erdpotential oder einem Potential des Nullleiters der Versorgungsspannung (U_{S}) entspricht.

6. Verfahren gemäß einem der vorherigen Ansprüche, **dadurch gekennzeichnet, dass** zwischen der Zwischenleiterbahn (5) und benachbarten Leiterbahnen des Eingangsteils (PRI) oder benachbarten Leiterbahnen des Ausgansteils (SEC) Aussparungen (7) in der Leiterplatte zur Erhöhung des Isolationsabstandes vorgesehen sind.

7. Leiterplatte mit einer Schaltungsanordnung, aufweisend:
- einen Eingangsteil (PRI) welcher von einer Versorgungsspannung (U_{S}) gespeist wird,
- einen Ausgangsteil (SEC),
**dadurch gekennzeichnet, dass** die Leiterplatte zwischen dem Eingangsteil (PRI) und dem Ausgangsteil (SEC) eine Zwischenleiterbahn aufweist, welche ein aus dem Eingangsteil abgeleitetes Zwischenpotential (ZP) aufweist,
wobei die Zwischenleiterbahn zu den benachbarten Leiterbahnen des Eingangsteils (PRI) einen funktionalen Isolationsabstand einhält,
wobei die Zwischenleiterbahn zu den benachbarten Leiterbahnen des Ausgangsteils (SEC) einen sicherheitsrelevanten Isolationsabstand einhält,
wobei das Zwischenpotential (ZP) eine Spannung gegenüber benachbarten Leiterbahnen des Ausgangsteils aufweist, die maximal der Versorgungsspannung (U_{S}) des Eingangsteils entspricht oder das Zwischenpotential (ZP) ein Potential mit einer dem Wert nach kleineren Spannung als der Spannung zwischen Eingangsteil und Ausgangsteil (U₁, U₂, U₃, U₄) gegenüber einem Erdpotential oder einem Potential des Nullleiters der Versorgungsspannung (U_{S}) aufweist.

8. Leiterplatte gemäß Anspruch 7, **dadurch gekennzeichnet, dass** das Eingangsteil (PRI) nicht berührbar ist.

9. Leiterplatte gemäß Anspruch 7 oder 8, **dadurch gekennzeichnet, dass** das Ausgangsteil (SEC) berührbare Bauteile aufweist.

10. Leiterplatte gemäß einem der Ansprüche 7 bis 9, **dadurch gekennzeichnet, dass** das Zwischenpotential (ZP) aus dem Potential am negativen Ausgang eines im Eingangsteil (PRI) befindlichen Brückengleichrichters erzeugt wird.

11. Leiterplatte gemäß einem der Ansprüche 7 bis 10, **dadurch gekennzeichnet, dass** zwischen der Zwischenleiterbahn (5) und benachbarten Leiterbahnen des Eingangsteils (PRI) oder benachbarten Leiterbahnen des Ausgangsteils (SEC) Aussparungen (7) in der Leiterplatte zur Erhöhung des Isolationsabstandes vorgesehen sind.

12. Leiterplatte gemäß einem der Ansprüche 7 bis 11, **dadurch gekennzeichnet, dass** das Zwischenpotential (ZP) einer niedrigeren Spannung als der Spannung zwischen Eingangsteil und Ausgangsteil (U₁, U₂, U₃, U₄) gegenüber einem Erdpotential oder einem Potential des Nullleiters der Versorgungsspannung (U_{S}) entspricht.

## Claims

1. Method for reducing conductor track spacings in a printed circuit board, wherein the printed circuit board has an input part (PRI), which is fed by a supply voltage (U_{S}), and has an output part (SEC), **characterized by** the following steps:
- inserting an intermediate conductor track which has an intermediate potential (ZP) which is derived from the input part (PRI),
- maintaining a functional insulation gap (F) between the intermediate conductor track (5) and adjacent conductor tracks of the input part (PRI),
- maintaining a safety-relevant insulation gap (S) between the intermediate conductor track and the adjacent conductor tracks of the output part (SEC),
wherein the intermediate potential has, with respect to adjacent conductor tracks of the output part (SEC), a voltage which corresponds at most to the supply voltage (U_{S}) of the input part.

2. Method according to Claim 1, **characterized in that** the input part (PRI) cannot be touched.

3. Method according to Claim 1 or 2, **characterized in that** the output part (SEC) has components which can be touched.

4. Method according to one of Claims 1 to 3, **characterized in that** the intermediate potential (ZP) is generated from the potential at the negative output of a bridge rectifier (3) which is located in the input part.

5. Method according to one of Claims 1 to 3, **characterized in that** the intermediate potential (ZP) has a potential which corresponds to a lower voltage than the voltage between the input part and the output part (U₁, U₂, U₃, U₄) with respect to a ground potential or a potential of the neutral conductor of the supply voltage (U_{S}).

6. Method according to one of the preceding claims, **characterized in that** cutouts (7) are provided in the printed circuit board, between the intermediate conductor track (5) and adjacent conductor tracks of the input part (PRI) or adjacent conductor tracks of the output part (SEC), for the purpose of increasing the insulation gap.

7. Printed circuit board comprising a circuit arrangement, having:
- an input part (PRI), which is fed by a supply voltage (U_{S}), and
- an output part (SEC),
**characterized in that** the printed circuit board has, between the input part (PRI) and the output part (SEC), an intermediate conductor track which has an intermediate potential (ZP) which is derived from the input part,
wherein the intermediate conductor track maintains a functional insulation gap from the adjacent conductor tracks of the input part (PRI),
wherein the intermediate conductor track maintains a safety-relevant insulation gap from the adjacent conductor tracks of the output part (SEC),
wherein the intermediate potential (ZP) has a voltage which corresponds at most to the supply voltage (U_{S}) of the input part with respect to adjacent conductor tracks of the output part, or the intermediate potential (ZP) has a potential with a voltage of which the value is lower than that of the voltage between the input part and the output part (U₁, U₂, U₃, U₄) with respect to a ground potential or a potential of the neutral conductor of the supply voltage (U_{S}).

8. Printed circuit board according to Claim 7, **characterized in that** the input part (PRI) cannot be touched.

9. Printed circuit board according to Claim 7 or 8, **characterized in that** the output part (SEC) has components which can be touched.

10. Printed circuit board according to one of Claims 7 to 9, **characterized in that** the intermediate potential (ZP) is generated from the potential at the negative output of a bridge rectifier which is located in the input part (PRI).

11. Printed circuit board according to one of Claims 7 to 10, **characterized in that** cutouts (7) are provided in the printed circuit board, between the intermediate conductor track (5) and adjacent conductor tracks of the input part (PRI) or adjacent conductor tracks of the output part (SEC), for the purpose of increasing the insulation gap.

12. Printed circuit board according to one of Claims 7 to 11, **characterized in that** the intermediate potential (ZP) corresponds to a lower voltage than the voltage between the input part and the output part (U₁, U₂, U₃, U₄) with respect to a ground potential or a potential of the neutral conductor of the supply voltage (U_{S}).

## Revendications

1. Procédé de réduction de distances entre pistes conductrices d'une carte de circuit imprimé, la carte de circuit imprimé présentant une partie d'entrée (PRI) alimentée par une tension d'alimentation (Us) et une partie de sortie (SEC), **caractérisé par** les étapes suivantes :
- insertion d'une piste conductrice intermédiaire qui présente un potentiel intermédiaire (ZP) dérivé de la partie d'entrée (PRI),
- respect d'une distance d'isolation fonctionnelle (F) entre la piste conductrice intermédiaire (5) et des pistes conductrices voisines de la partie d'entrée (PRI),
- respect d'une distance d'isolation de sécurité (S) entre la piste conductrice intermédiaire et les pistes conductrices voisines de la partie de sortie (SEC),
le potentiel intermédiaire présentant, par rapport à des pistes conductrices voisines de la partie de sortie (SEC), une tension qui correspond au maximum à la tension d'alimentation (Us) de la partie d'entrée.

2. Procédé selon la revendication 1, **caractérisé en ce qu'**il n'est pas possible de toucher la partie d'entrée (PRI).

3. Procédé selon la revendication 1 ou 2, **caractérisé en ce que** la partie de sortie (SEC) comporte des composants qu'il est possible de toucher.

4. Procédé selon l'une des revendications 1 à 3, **caractérisé en ce que** le potentiel intermédiaire (ZP) est généré à partir du potentiel à la sortie négative d'un redresseur en pont (3) situé dans la partie d'entrée.

5. Procédé selon l'une des revendications 1 à 3, **caractérisé en ce que** le potentiel intermédiaire (ZP) présente un potentiel qui correspond à une tension plus faible que la tension entre la partie d'entrée et la partie de sortie (U1, U2, U3, U4) par rapport à un potentiel de terre ou un potentiel du conducteur neutre de la tension d'alimentation (Us).

6. Procédé selon l'une des revendications précédentes, **caractérisé en ce que** sont prévus, entre la piste conductrice intermédiaire (5) et des pistes conductrices voisines de la partie d'entrée (PRI) ou des pistes conductrices voisines de la partie de sortie (SEC), des évidements (7) ménagés dans la carte de circuit imprimé pour augmenter la distance d'isolation.

7. Carte de circuit imprimé avec un circuit, comportant :
- une partie d'entrée (PRI) qui est alimentée par une tension d'alimentation (Us),
- une partie de sortie (SEC),
**caractérisée en ce que** la carte de circuit imprimé présente, entre la partie d'entrée (PRI) et la partie de sortie (SEC), une piste conductrice intermédiaire qui présente un potentiel intermédiaire (ZP) dérivé de la partie d'entrée, la piste conductrice intermédiaire respectant une distance d'isolation fonctionnelle par rapport aux pistes conductrices voisines de la partie d'entrée (PRI),
la piste conductrice intermédiaire respectant une distance d'isolation de sécurité par rapport aux pistes conductrices voisines de la partie de sortie (SEC),
le potentiel intermédiaire (ZP) présentant, par rapport à des pistes conductrices voisines de la partie de sortie, une tension qui correspond au maximum à la tension d'alimentation (Us) de la partie d'entrée ou le potentiel intermédiaire (ZP) présentant un potentiel avec une tension plus faible, en termes de valeur, que la tension entre la partie d'entrée et la partie de sortie (U1, U2, U3, U4) par rapport à un potentiel de terre ou un potentiel du conducteur neutre de la tension d'alimentation (Us).

8. Carte de circuit imprimé selon la revendication 7, **caractérisée en ce qu'**il n'est pas possible de toucher la partie d'entrée (PRI).

9. Carte de circuit imprimé selon la revendication 7 ou 8, **caractérisée en ce que** la partie de sortie (SEC) comporte des composants qu'il est possible de toucher.

10. Carte de circuit imprimé selon l'une des revendications 7 à 9, **caractérisée en ce que** le potentiel intermédiaire (ZP) est généré à partir du potentiel à la sortie négative d'un redresseur en pont situé dans la partie d'entrée (PRI).

11. Carte de circuit imprimé selon l'une des revendications 7 à 10, **caractérisée en ce que** sont prévus, entre la piste conductrice intermédiaire (5) et des pistes conductrices voisines de la partie d'entrée (PRI) ou des pistes conductrices voisines de la partie de sortie (SEC), des évidements (7) ménagés dans la carte de circuit imprimé pour augmenter la distance d'isolation.

12. Carte de circuit imprimé selon l'une des revendications 7 à 11, **caractérisé en ce que** le potentiel intermédiaire (ZP) correspond à une tension plus faible que la tension entre la partie d'entrée et la partie de sortie (U1, U2, U3, U4) par rapport à un potentiel de terre ou un potentiel du conducteur neutre de la tension d'alimentation (Us).
